(19) Europäisches Patentamt
European Patent Office
Office européen des brevets

(11) Veröffentlichungsnummer: **0 077 535**
**B1**

(12) # EUROPÄISCHE PATENTSCHRIFT

(45) Veröffentlichungstag der Patentschrift: **29.01.86**

(21) Anmeldenummer: **82109524.7**

(22) Anmeldetag: **14.10.82**

(51) Int. Cl.⁴: **C 23 C 16/14**, H 01 C 17/20, H 01 G 1/01, H 01 L 21/285, C 23 F 11/00

(54) **Verfahren zum Herstellen von Schichten aus hochschmelzenden Metallen bei niedrigen Substrattemperaturen.**

(30) Priorität: **20.10.81 DE 3141567**

(43) Veröffentlichungstag der Anmeldung: **27.04.83 Patentblatt 83/17**

(45) Bekanntmachung des Hinweises auf die Patenterteilung: **29.01.86 Patentblatt 86/5**

(84) Benannte Vertragsstaaten: **AT CH FR GB LI NL**

(56) Entgegenhaltungen:
**DE - A - 2 525 482**
**DE - A - 2 718 026**
**DE - B - 2 151 127**
**DE - B - 2 718 518**

**CHEMICAL VAPOR DEPOSITION, Fourth International Conferencel, Edited by G.F. Wakefield and J.M. Blocher, Jr.; The Electrochemical Society, Inc., Princeton, New Jersey, J. LO et al. "A CVD Study of the Tungsten-Silicon System" Seiten 74-90**

(73) Patentinhaber: **Siemens Aktiengesellschaft, Berlin und München Wittelsbacherplatz 2, D-8000 München 2 (DE)**

(72) Erfinder: **Wieczorek, Claudia, Ing. grad., Ostpreussenstrasse 2, D-8012 Ottobrunn (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

**Beschreibung**

Die vorliegende Patentanmeldung betrifft ein Verfahren zum Herstellen von aus Tantal, Wolfram oder Molybdän bestehenden Schichten auf Substraten bei niedrigen Substrattemperaturen, wobei als Ausgangsmaterialien die Halogenide dieser Metalle verwendet werden, die in Gegenwart von Silan ($SiH_4$) aus der Gasphase thermisch zersetzt und reduziert werden.

In der Dünnschicht- und Halbleitertechnik werden metallische Schichten als Widerstände, Elektroden für Kondensatoren und als Induktivitäten, auf strukturierten Halbleiterkristallscheiben als Leiterbahnen verwendet. Ausserdem werden Metallbeschichtungen auch als Korrosions- und Verschleissschutz bei kompliziert geformten Werkstücken verwendet.

Für die Herstellung solcher Schichten kommen die unterschiedlichsten Verfahren, wie zum Beispiel die galvanische Abscheidung, das Aufdampfen, das Ionenplattieren oder auch das Aufstäuben zum Einsatz. Allen Methoden der Schichtgewinnung ist gemeinsam, dass das Material im Vergleich zu seinem Schmelzpunkt bei niedrigen Temperaturen und in Anwesenheit von Fremdatomen abgeschieden wird. Niedrige Temperaturen sind beispielsweise möglich bei der galvanischen Abscheidung. Diese Art der Abscheidung ist aber bei hochschmelzenden Metallen, wie Tantal, Wolfram und Molybdän nicht durchführbar, da sich diese Metalle galvanisch nicht abscheiden lassen.

Wichtig bei der Schichtherstellung auf strukturierten Halbleiterkristallscheiben ist die Kantenbedeckung. Mit Hilfe des CVD (chemical vapour disposition)-Verfahrens lässt sich zwar eine ausgezeichnete Kantenbedeckung erreichen, doch ist die Abscheidung für hochschmelzende Metalle nur bei hohen Temperaturen möglich, was bei einer Mehrlagenverdrahtung wegen der Empfindlichkeit der bereits hergestellten Bauelemente nicht durchführbar ist.

Es werden deshalb für solche Beschichtungen modifizierte CVD-Verfahren vorgeschlagen, bei denen die Reaktionstemperaturen entweder durch den Einsatz metallorganischer Ausgangsverbindungen oder durch Anwendung eines Hochfrequenzplasmas als Energiequelle erniedrigt werden. Durch die Verwendung metallorganischer Ausgangsverbindungen (siehe Zeitschrift für Werkstofftechnik/J. of Materials Technology, 4. Jahrgang, 1973, Nr. 7, S. 379 bis 386) lassen sich Metalle und deren Verbindungen, wie Oxide, Nitride und Karbide herstellen, jedoch werden hier, bedingt durch die organische Komponente, Verunreinigungen beim Beschichten miteingebaut.

Durch die Anwendung eines Hochfrequenzplasmas als Energiequelle können Beschichtungen aus Silizium und dessen Verbindungen hergestellt werden, eine Abscheidung von Metallen ist noch nicht bekannt.

Ein Verfahren zur CVD-Abscheidung von hochschmelzenden Metallen ist aus der DE-OS 2445564 zu entnehmen. Dabei wird eine Beschichtung von Innenflächen von Hohlkörpern mit Tantal mittels eines CVD-Verfahrens durchgeführt, wobei Tantalchlorid mit Wasserstoff gemischt bei einem Druck von $5.3 \times 10^4$ Pa (= 400 Torr) durch den zu beschichtenden beheizten Hohlkörper geleitet und Tantal gemäss der Reaktion

$$2\,TaCl_5 + 5\,H_2 \rightarrow 2\,Ta + 10\,HCl$$

an der Innenwandung im Bereich der Heizzone niedergeschlagen wird. Die Reaktionstemperatur liegt dabei über 600°C.

Die Aufgabe, die der Erfindung zugrundeliegt, besteht in der Herstellung von hochschmelzenden reinen Metallschichten aus Tantal, Wolfram oder Molybdän, wie sie insbesondere für eine Mehrlagenverdrahtung auf strukturierten Halbleiterkristallscheiben verwendet werden. Dabei soll wegen der guten Kantenbedeckung ein CVD-Verfahren (Niederschlag durch thermische Zersetzung und Reduktion) bei niedrigen Reaktionstemperaturen anwendbar sein.

Diese Aufgabe wird erfindungsgemäss dadurch gelöst, dass die Halogenide dieser Metalle in Gegenwart von Silan ($SiH_4$) bei Temperaturen $<500°C$ und im Druckbereich von 25 Pa bis $11 \times 10^3$ Pa aus der Gasphase thermisch zersetzt und reduziert werden. Dabei findet folgende Reaktion statt

$$AB_{gas} + CD_{gas} \rightarrow A_{fest} + CB_{gas} + D_{gas}$$

wobei AB = Halogenid von Tantal, Wolfram, Molybdän, CD = Silan, CB = Siliziumhalogenid und D = Wasserstoff. Wesentlich ist, dass die Temperatur für die thermische Zersetzung bzw. Reduktion der Einzelkomponenten (AB, CD) höher liegt als bei der Mischung (AB + CD).

Eine ähnliche Reaktion ist aus einem Aufsatz von Lo et al «A CVD Study of the Tungsten-Silicon System» aus Proceedings of the Fourth International Conference on CVD, 1973, S. 74 bis 90, bekannt. Dabei wurde festgestellt, dass bereits bei 280°C eine einfache Abscheidung einer Wolfram-Silizium-Mischung durch thermische Zersetzung und Reduktion von Wolframhexafluorid ($WF_6$) mit Silan ($SiH_4$) möglich ist und dass die Abscheiderate einer $WSi_2$-Schicht 20 bis 37 mal schneller ist als eine Festkörperdiffusion.

Es liegt im Rahmen des Erfindungsgedankens, dass die gasförmigen Ausgangsverbindungen durch die Heizzone eines Reaktors geleitet, dort zersetzt, die Metalle auf den Substraten niedergeschlagen und die entstehenden gasförmigen Zersetzungsprodukte aus der Reaktionszone weggeführt werden, wobei zur Aufrechterhaltung und Unterstützung einer laminaren Strömung im Reaktionsraum zusätzliche Trägergase, bestehend aus Wasserstoff und/oder Edelgasen verwendet werden. Die Ableitung der Zersetzungsprodukte ist für die Schichtreinheit von grosser Bedeutung.

Gemäss einem Ausführungsbeispiel nach der Lehre der Erfindung werden sehr reine und bezüglich ihrer Schichtdicke sehr homogene Wolframschichten ausgehend von Wolframhexafluorid ($WF_6$) und Silan ($SiH_4$) bereits bei 150°C (im allgemeinen bei Temperaturen von 120 bis 200°C) hergestellt. Allgemein lassen sich auf diese Weise, ausgehend von den entsprechenden Halogeniden, zum Beispiel Tantalchlorid ($TaCl_5$) und Molybdänchlorid ($MoCl_5$) Metallschichten aus Tantal und Molybdän herstellen.

Die erfindungsgemässen Metallschichten zeichnen sich bei ihrer Verwendung als Leiterbahnstrukturen bei der Herstellung von integrierten Halbleiterschaltkreisen durch eine gute Kantenbedeckung und eine hohe thermische Stabilität aus. Bei der Beschichtung von Werkstücken sind sie in bezug auf Korrosions- und Verschleissschutz mit Werkstücken aus teuren und hochtemperaturbeständigen Grundwerkstoffen vergleichbar.

Die Abscheidung der Metallschichten kann in allen kommerziellen CVD-Apparaturen durchgeführt werden.

Im folgenden wird ein Ausführungsbeispiel der Erfindung anhand der in der Zeichnung befindlichen Figur, welche schematisch ein Schnittbild durch eine horizontale Beschichtungsvorrichtung darstellt, beschrieben. Dabei wird die Abscheidung einer aus Wolfram bestehenden Metallschicht kurz erläutert.

Die aus Wolframhexafluorid und Silan bestehenden Ausgangsverbindungen (AB, CD) werden in der Gaszusammensetzung zwei Volumenteile Wolframhexafluorid und drei Volumenteile Silan an dem mit dem Pfeil 1 bezeichneten Gaseinlass in das aus Quarz bestehende Reaktorrohr 2 eingeleitet und im Bereich der durch den Rohrofen 3 auf 150°C gehaltenen Heizzone bei einem Druck von 60 Pa bis $1{,}3\times10^3$ Pa gemäss der Reaktion

$$2\,WF_6 + 3\,SiH_4 \rightarrow 2\,W + 3\,SiF_4 + 6\,H_2$$

zersetzt. Dabei stellt sich auf den in der Heizzone befindlichen Substraten 4 eine Aufwachsrate von Wolfram von 5 bis 15 µm/h ein. Die aus Wasserstoff und Siliziumtetrafluorid bestehenden Zersetzungsprodukte verlassen an dem mit dem Pfeil 5 bezeichneten Gasauslass, an dem auch die Pumpe für die Einstellung des Druckes angeschlossen ist, den Reaktionsraum (2). Mit dem Bezugszeichen 6 und 7 sind die das Quarzrohr 2 tragenden Halterungen bezeichnet.

In gleicher Weise wie Wolfram lassen sich auch Tantal- und Molybdänschichten niederschlagen. Der Temperaturbereich der Heizzone liegt für Tantalchlorid bei 350 bis 500°C, für Molybdänchlorid bei 250 bis 450°C. Die Gaszusammensetzung erfolgt entsprechend der Reaktionsgleichung im gleichen Druckbereich.

**Patentansprüche**

1. Verfahren zum Herstellen von aus Tantal, Wolfram oder Molybdän bestehenden Schichten auf Substraten bei niedrigen Temperaturen, wobei als Ausgangsmaterialien die Halogenide dieser Metalle verwendet werden, die in Gegenwart von Silan ($SiH_4$) bei Temperaturen <500°C und im Druckbereich von 25 Pa bis $11\times10^3$ Pa aus der Gasphase thermisch zersetzt und reduziert werden.

2. Verfahren nach Anspruch 1, dadurch gekennzeichnet, dass zur Aufrechterhaltung einer laminaren Strömung im Reaktionsraum zusätzlich Trägergase, bestehend aus Wasserstoff und/oder Edelgasen verwendet werden.

3. Verfahren nach Anspruch 1 und 2, dadurch gekennzeichnet, dass zur Herstellung einer aus Wolfram bestehenden Metallschicht als Ausgangsverbindungen Wolframhexafluorid ($WF_6$) und Silan ($SiH_4$) verwendet werden und dass die thermische Zersetzung und Reduktion mittels einer, in einem Reaktorrohr befindlichen Heizzone von 120 bis 200°C, durch welche die Verbindungen geleitet werden, bewirkt wird.

4. Verfahren nach Anspruch 1 und 2, dadurch gekennzeichnet, dass zur Herstellung einer aus Tantal bestehenden Metallschicht als Ausgangsverbindungen Tantalchlorid ($TaCl_5$) und Silan ($SiH_4$) verwendet werden und dass die thermische Zersetzung und Reduktion mittels einer in einem Reaktorrohr befindlichen Heizzone von 350 bis 500°C, durch welche die Verbindungen geleitet werden, bewirkt wird.

5. Verfahren nach Anspruch 1 und 2, dadurch gekennzeichnet, dass zur Herstellung einer aus Molybdän bestehenden Metallschicht als Ausgangsverbindungen Molybdänchlorid ($MoCl_5$) und Silan ($SiH_4$) verwendet werden und dass die thermische Zersetzung und Reduktion mittels einer in einem Reaktorrohr befindlichen Heizzone von 250 bis 450°C, durch welche die Verbindungen geleitet werden, bewirkt wird.

6. Verwendung des Verfahrens nach Anspruch 1 bis 5, zur Herstellung von metallischen Schichten als Leiterbahnen in der Halbleitertechnik.

7. Verwendung des Verfahrens nach Anspruch 1 bis 5, zur Herstellung von metallischen Schichten als Widerstände, Elektroden für Kondensatoren und als Induktivitäten in der Dünnschichttechnologie.

8. Verwendung des Verfahrens nach Anspruch 1 bis 5, zur Herstellung von korrosionsfesten und verschleissfesten Metallbeschichtungen der Innen- und/oder Aussenflächen von Werkstücken.

**Claims**

1. A method for the production of layers, consisting of tantalum, tungsten or molybdenum on substrates at low temperatures, wherein the halides of these metals are used as starting materials, which in the presence of silane ($SiH_4$) are thermally decomposed and reduced from the gas phase at temperatures <500°C and in the pressure range of 25 Pa to $11\times10^3$ Pa.

2. A method as claimed in claim 1, characterised in that, in order to maintain a laminar flow in the reaction chamber, additional carrier gases, consisting of hydrogen and/or rare gases, are used.

3. A method as claimed in claim 1 and 2, characterised in that, in order to produce a tungsten metal layer, tungsten hexafluoride ($WF_6$) and silane ($SiH_4$) are used as starting compounds; and that the thermal decomposition and reduction is effected by means of a heating zone of 120 to

200°C, present in a reactor tube through which the compounds are led.

4. A method as claimed in claim 1 and 2, characterised in that in order to produce a tantalum metal layer, tantalum chloride ($TaCl_5$) and silane ($SiH_4$) are used as starting compounds; and that the thermal decomposition and reduction is effected by means of a heating zone of 350 to 500°C present in a reactor tube through which the compounds are led.

5. A method as claimed in claim 1 and 2, characterised in that in order to produce a molybdenum metal layer, molybdenum chloride ($MoCl_5$) and silane ($SiH_4$) are used as starting compounds; and that the thermal decomposition and reduction is effected by means of a heating zone of 250 to 450°C present in a reactor tube through which the compounds are led.

6. The use of the method as claimed in claim 1 to 5, for the production of metallic layers as conductor paths in semiconductor technology.

7. The use of the method as claimed in claim 1 to 5, for the production of metallic layers as resistors, electrodes for capacitors and as inductances in thinfilm technology.

8. The use of the method as claimed in claim 1 to 5, for the production of corrosion-resistant and wear-resistant metal coatings for the inner and/or outer surfaces of workpieces.

**Revendications**

1. Procédé de fabrication de couches en tantale, en tungstène ou en molybdène sur des substrats à des températures basses, en utilisant comme matériaux de départ les halogénures de ces métaux, qui sont décomposés thermiquement et réduits en phase gazeuse en présence de silane ($SiH_4$) à des températures inférieures à 500°C dans la plage des pressions de 25 Pa à $11 \times 10^3$ Pa.

2. Procédé suivant la revendication 1, caractérisé en ce qu'il consiste, pour maintenir un écoulement laminaire dans la chambre de réaction, à utiliser des gaz porteurs supplémentaires constitués d'hydrogène et/ou de gaz rares.

3. Procédé suivant la revendication 1 et 2, caractérisé en ce qu'il consiste, pour la fabrication d'une couche métallique en tungstène à utiliser comme composés de départ de l'hexafluorure de tungstène ($WF_6$) et du silane ($SiH_4$) et à effectuer la décomposition thermique et la réduction au moyen d'une zone de chauffage de 120 à 200°C, qui se trouve dans le tube formant réacteur et dans laquelle passent les composés.

4. Procédé suivant la revendication 1 et 2, caractérisé en ce qu'il consiste, pour la fabrication d'une couche métallique en tantale, à utiliser comme composés de départ du chlorure de tantale ($TaCl_5$) et du silane ($SiH_4$) et à effectuer la décomposition thermique et la réduction au moyen d'une zone de chauffage de 350 à 500°C, qui se trouve dans un tube formant réacteur et dans laquelle passent les composés.

5. Procédé suivant la revendication 1 et 2, caractérisé en ce qu'il consiste, pour la fabrication d'une couche métallique en molybdène, à utiliser comme composés de départ du chlorure de molybdène ($MoCl_5$) et du silane ($SiH_4$) et à effectuer la décomposition thermique et la réduction au moyen d'une zone de chauffage de 250 à 450°C, qui se trouve dans un tube formant réacteur et dans laquelle passent les composés.

6. Utilisation du procédé suivant la revendication 1 à 5 pour la fabrication de couches métalliques servant de pistes conductrices dans la technique des semi-conducteurs.

7. Utilisation du procédé suivant la revendication 1 à 5, pour la fabrication de couches métalliques servant de résistances, d'électrodes pour des condensateurs et d'inductances dans la technologie en couche mince.

8. Utilisation du procédé suivant la revendication 1 à 5 pour la fabrication de revêtements métalliques résistants à la corrosion et résistants à l'usure sur les surfaces intérieures et/ou extérieures de pièces.

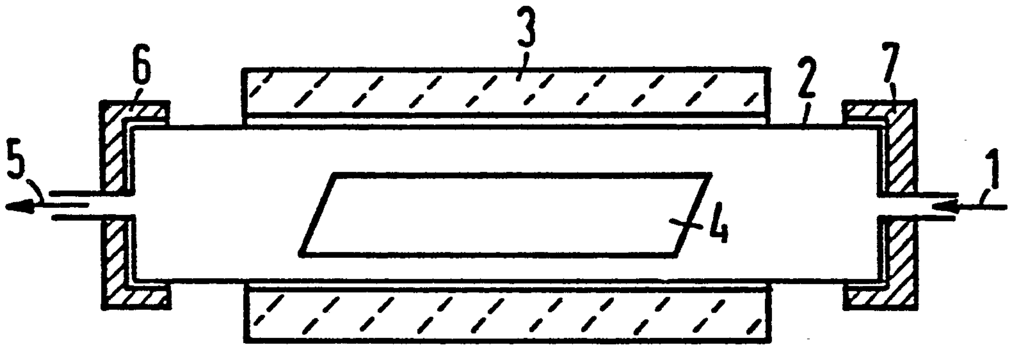
3
6
2
7
5
1
4